(19) Europäisches Patentamt
European Patent Office
Office européen des brevets

(11) **EP 2 420 869 A2**

(12) # EUROPEAN PATENT APPLICATION

(43) Date of publication:
**22.02.2012 Bulletin 2012/08**

(51) Int Cl.:
***G02B 5/02*** (2006.01)

(21) Application number: **11177643.1**

(22) Date of filing: **16.08.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.08.2010 JP 2010181884**

(71) Applicant: **Fujifilm Corporation**
**Minato-ku**
**Tokyo (JP)**

(72) Inventors:
• **Hatanaka, Yusuke**
  **Shizuoka (JP)**
• **Hotta, Yoshinori**
  **Shizuoka (JP)**

(74) Representative: **HOFFMANN EITLE**
**Patent- und Rechtsanwälte**
**Arabellastraße 4**
**81925 München (DE)**

(54) **Radiation reflection plate for LED**

(57)     A radiation reflection plate for use in LEDs is a reflection plate including an aluminum alloy layer with a depth of at least 10 μm and an anodized film formed at a surface thereof. Pore portions of the anodized film have at least two layers of different refractive indices in a depth direction, and light reflection is enhanced in the anodized film. The radiation reflection plate has high heat dissipation properties and is capable of increasing the reflectance of light at desired specific wavelengths.

FIG. 3

EP 2 420 869 A2

**Description**

TECHNICAL FIELD

The present invention relates to a radiation reflection plate for use in light-emitting devices. The invention more specifically relates to a radiating and light-reflecting substrate for use in light-emitting diodes (hereinafter referred to as "LEDs") and particularly to a radiation reflection plate capable of increasing the reflectance of light at desired specific wavelengths.

It is said that LEDs generally use as little as one-hundredth of the electricity consumed in fluorescent lamps and have a lifetime forty times longer than that of fluorescent lamps (40,000 hours). The characteristics including power saving and longer lifetime are important elements based on which LEDs are adopted in the environment-oriented society.

In particular, white LEDs also have merits including excellent color rendering properties and simpler power circuit than fluorescent lamps and therefore expectations are rising for their use in illumination light sources.

Recently, white LEDs with high luminous efficiency (30 to 150 lm/W) required for the illumination light source successively appeared on the market and replaces fluorescent lamps (20 to 110 lm/W) in the light use efficiency during practical use.

This sharply accelerated the trend for practical application of white LEDs instead of fluorescent lamps and there are an increasing number of cases where white LEDs are adopted for the backlight and illumination light source in liquid crystal display devices.

It is known to anodize aluminum and to use the resulting anodized film as the insulating layer in a circuit board (see, for example, JP 55-154564 U, JP 2007-250315 A and JP 2007-266358 A.)

However, when used as the mounting board of light-emitting devices such as LEDs which are recently under development, the anodized film suffers from lack of surface reflectance. The LED devices are widely used in various fields such as indoor and outdoor lighting, automobile headlights and backlight units in display devices, which inevitably requires high reflectance of light at desired specific wavelengths.

SUMMARY OF THE INVENTION

An object cf the invention is to provide a radiation reflection plate having high heat dissipation properties and capable of increasing the reflectance of light at desired specific wavelengths. Another object of the invention is to provide a radiation reflection plate capable of meeting the foregoing properties at lower cost.

The inventors of the invention have made an intensive study to achieve the foregoing objects and as a result found that in a light reflection layer which includes aluminum metal inherently having high heat resistance and high durability and an anodized film thereof, the light reflectance can be increased while also improving the heat dissipation properties when the anodized film has a plurality of layers of different shapes and physical properties, and the invention has been thus completed.

It has also been found that the aluminum alloy layer should only be present at a portion to be anodized and the same properties can be achieved if a substrate having a core made of other material is used and its surface layer is only the aluminum alloy layer, and a radiation reflection plate can be provided at lower cost by using a low-purity aluminum alloy sheet or a steel sheet for the core. The invention has been thus completed.

Accordingly the present invention provides the following (1) to (10).

The refractive index and porosity as used herein refer to an average refractive index and an average porosity in one of layers making up an anodized film and are hereinafter abbreviated as "refractive index" and "porosity", respectively. The one layer comprises pore portions formed with a same depth and an alumina layer surrounding the pore portions formed with the same depth.

(1) A radiation reflection plate for use in LEDs comprising an aluminum alloy layer having an anodized film with a depth of at least 1 $\mu$m or more formed at a surface thereof,
wherein the anodized film comprises pore portions, and
the at least one pore portion comprises at least two layers which have different refractive indices in a depth direction.
(2) The radiation reflection plate four use in LEDs according to (1), wherein the layers having the at least one pore portion comprising at least two layers are layers of different porosities, and wherein when layers adjacent in the depth direction under a surface side layer p are represented by p+1, p+2, ... p+n, a vertical depth L of the layer p+1 is represented by formulas (1), (2-1) and (2-2) :

$$L = 1/2 \times m \times \lambda \times n_{avp}/n_{avp+1} \qquad \text{Formula (1)}$$

$$n_{avp} = n_{Al2O3} \times (1-D_p) + n_{air} \times D_p \qquad \text{Formula (2-1)}$$

$$n_{avp+1} = n_{Al2O3} \times (1-D_{p+1}) + n_{air} \times D_{p+1} \qquad \text{Formula (2-2)}$$

where $\lambda$ is a wavelength of light for reflection, m is an integer of at least 1, $n_{avp}/n_{avp+1}$ is an refractive index ratio between the surface side layer p of the anodized film and its underlying layer p+1 in the at least two different layers, $n_{Al2O3}$ is a refractive index of anodized alumina, $n_{air}$ is a refractive index of air which is 1, $n_{avp}$ is a refractive index of the layer p, $n_{avp+1}$ is a refractive index of the layer p+1, $D_p$ is a porosity of the layer p, and $D_{p+1}$ is a porosity of the layer p+1.

(3) The radiation reflection plate for use in LEDs according to (1) or (2), wherein the at least two layers are layers of the different porosities obtained by anodizing under different conditions.

(4) The radiation reflection plate for use in LEDs according to any one of (1) to (3), wherein a ratio of a centerline length of the pore portions to a depth of the pore portions is from 1.0 to 1.2.

(5) The radiation reflection plate for use in LEDs according to any one of (1) to (4), wherein the aluminum alloy layer is in a shape having a recess and the anodized film is formed at the surface of the aluminum alloy layer in the shape having the recess.

(6) The radiation reflection plate for use in LEDs according to any one of (1) to (5), which has an interconnect layer made of a metal conductor on a surface of the anodized film and is used to mount a light-emitting device.

(7) An LED package comprising: an LED chip and an interconnect layer made of a metal conductor on a surface of the radiation reflection plate for use in LEDs according to any one of (1) to (6).

(8) A white LED package comprising: a blue LED light-emitting device formed on the radiation reflection plate for use in LEDs according to any one of (1) to (6) and a fluorescent emitter provided around and/or above the blue LED light-emitting devices.

(9) A method of manufacturing the radiation reflection plate for use in LEDs according to any one of (1) to (6) comprising the steps of: subjecting a surface of an aluminum alloy layer to a first anodizing treatment in an aqueous acid solution; and performing a second anodizing treatment in an aqueous acid solution different from that used in the first anodizing treatment to form in pore portions of an anodized film at least two layers of different refractive indices in a depth direction.

(10) A method of manufacturing the radiation reflection plate for use in LEDs according to any one of (1), (2) and (4) to (6), comprising the steps of: subjecting a surface of an aluminum alloy layer to a first anodizing treatment in an aqueous acid solution; and performing sealing treatment to form in pore portions of an anodized film at least two layers of different refractive indices in a depth direction.

As will be described later, this invention can provide a radiation reflection plate for LEDs (hereinafter referred to as "radiation reflection plate") having high heat dissipation properties and capable of increasing the light reflectance.

BRIEF DESCRIPTION OF THE DRAWINGS

FIG. 1 is a graph showing an example of an alternating current waveform that may be used to perform electrochemical graining treatment in the manufacture of a radiation reflection plate of the invention.
FIG. 2 is a schematic view of an anodizing apparatus that may be used to perform anodizing treatment in the manufacture of the radiation reflection plate of the invention.
FIG. 3 is a schematic cross-sectional view showing an embodiment of the radiation reflection plate which includes the anodized film-bearing aluminum alloy layer according to the invention.
FIG. 4 is a schematic view showing the configuration of a phosphor color mixed type white light emitting unit.
FIGS. 5A and 5B schematically illustrate white light emitting units each using another embodiment of the radiation reflection plate according to the invention.

DETAILED DESCRIPTION OF THE INVENTION

Next, the radiation reflection plate according to the invention is described in detail.
The radiation reflection plate of the invention includes an aluminum alloy layer at the surface of which an anodized film including at least two layers of different refractive indices is formed.

The anodized film having at least two layers of different refractive indices has layers p+1, p+2 ... p+n in the depth direction with respect to a layer p located on the surface side. When the depth of the layer p+1 is represented by L, there is an optical path difference of 2L between light A reflecting on the bottom of the layer p located on the surface side and light B reflecting on the bottom of the layer p+1. The ratio $n_{av1}/n_{av2}$ as used herein refers to the refractive index ratio between two different layers in the anodized film. When the optical path difference is the integral multiple of the wavelength $\lambda$ of reflected light multiplied by $n_{av1}/n_{av2}$, the waveforms of light A and light B overlap each other to cause interference, thereby obtaining a reflection plate having enhanced light reflection.

1. [Anodized film having at least two layers of different refractive indices in its depth direction]

The anodized film having at least two layers of different refractive indices is one having a plurality of layers of different shapes and physical properties and has at least two layers of different refractive indices. And one of the layers comprises pore portions formed with the same depth and an alumina layer formed with the same depth surrounding the pore portions.

A plurality of layers of different refractive indices may be obtained by performing anodizing treatment under different conditions. Alternatively, anodizing treatment may be followed by sealing treatment or filling treatment to form a plurality of layers. The refractive index varies with the shape of the anodized film, porosity and conditions of the material used for filling. Except the case where the anodized film is filled with a special substance, alumina, aluminum hydroxide or a hydrous oxide thereof is present as a porous material in the pore portions of the anodized film, and the porosity varies with the anodizing treatment conditions. The anodized film of the invention includes the case in which the anodized film contains a large number of micropores having an Average aperture size and the case In which such micropores cannot be observed and alumina, aluminum hydroxide or a hydrous oxide thereof is filled into the portions corresponding to the pore portions.

2. [Anodized film having at least two layers of different porosities]

The radiation reflection plate includes an aluminum alloy layer and an anodized film formed at the surface thereof, the anodizing film having at least two anodized layers of different porosities in the depth direction from the surface of the anodized film to the interface between the aluminum alloy layer and the anodized film. When the layers adjacent in the depth direction under the surface side layer p are represented by p+1, p+2, ... p+n, respectively, the vertical depth L of the layer p+1 is represented by formulas (1), (2-1) and (2-2):

$$L = 1/2 \times m \times \lambda \times n_{avp}/n_{avp+1} \qquad \text{Formula (1)}$$

$$n_{avp} = n_{Al2O3} \times (1-D_p) + n_{air} \times D_p \qquad \text{Formula (2-1)}$$

$$n_{avp+1} = n_{Al2O3} \times (1-D_{p+1}) + n_{air} \times D_{p+1} \qquad \text{Formula (2-2)}$$

where $\lambda$ is the wavelength of light for reflection, m is an integer of at least 1, $n_{avp}/n_{avp+1}$ is the refractive index ratio between the surface side layer (layer p) of the anodized film and the underlying layer (layer p+1) in at least two different anodized layers,
$n_{Al2O3}$ is the refractive index of anodized alumina, $n_{air}$ is the refractive index of air which is 1,
$D_p$ is the porosity of the layer p, and
$D_{p+1}$ is the porosity of the layer p+1.

$$n_{av1} = n_{Al2O3} \times (1-D_1) + n_{air} \times D_1 \qquad \text{Formula (3)}$$

$$n_{av2} = n_{Al2O3} \times (1-D_2) + n_{air} \times D_2 \qquad \text{Formula (4)}$$

(1) A case is considered in which pore portions corresponding to micropores in a first anodized layer obtained by a first anodizing treatment have a porosity of 0.33 (33%) and pore portions in a second anodized layer obtained by a second anodizing treatment and having a vertical depth L have a porosity of 0 (0%). Assuming that the first anodized layer is the surface layer of the anodized film and the second anodized layer is the underlying layer thereof, by substituting the refractive index of alumina (1.6), and the porosities of the first and second anodized layers into formulas
(3) and (4), we obtain

$$n_{av1} = 1.6 \times (1-0.33) + 1 \times 0.33 = 1.4$$

$$n_{av2} = 1.6 \times (1-0) + 1 \times 0 = 1.6$$

$$n_{av1}/n_{av2} = 1.4/1.6$$

Here, in cases where light at a wavelength of 450 nm enters the first anodized layer and the second anodized layer, when the waveform of light B which entered the second anodized layer, reflected on the bottom thereof and traveled on the optical path with a length of 2L and that of light A which reflected on the bottom of the first anodized layer overlap each other, the relation of formula (1) is met and reflection is enhanced.
Hence,

$$L = 1/2 \times m \times 450 \times 1.4/1.6.$$

Reflection is enhanced at a depth L of 197 nm when m is 1 and at a depth L of 394 nm when m is 2.
(2) Another case is considered in which pore portions corresponding to micropores in a first anodized layer obtained by the first anodizing treatment have porosity of 33%, the pore portions of the first anodized layer are sealed to form a first layer with a porosity of 0% on the surface side of the pore portions, and the bottoms of the pore portions and the surrounding alumina portion obtained by the first anodizing treatment are remained still as a second layer 2 with the vertical depth L having a porosity of 0.33 (33%). By substituting the refractive index of alumina (1.6), and the porosities of the first and second layers into formulas (3) and (4), we obtain

$$n_{av1} = 1.6 \times (1-0) + 1 \times 0 = 1.6$$

$$n_{av2} = 1.6 \times (1-0.33) + 1 \times 0.33 = 1.4$$

$$n_{av1}/n_{av2} = 1.6/1.4$$

Here, in cases where light at a wavelength of 450 nm enters the first layer and the second layer, when the waveform of light B which entered the second layer, reflected on the bottom thereof and traveled on the optical path with a length of 2L and that of light A which reflected on the bottom of the first layer overlap each other, the relation of formula (1) is met and reflection is enhanced. Hence,

$$L = 1/2 \times m \times 450 \times 1.6/1.4.$$

Reflection is enhanced at a depth L of 257 nm when m is 1 and at a depth L of 514 nm when m is 2.
(3) For example, in cases where pore portions of a first anodized film obtained by the first anodizing treatment have a porosity of 0.33 (33%), those of a second anodized film obtained by the second anodizing treatment have a vertical depth L and a porosity of 0.42 (42%) and those of a third anodized film obtained by the third anodizing treatment have a porosity of 0.33 (33%), and the first anodized layer is the surface side layer of the anodized film and the second and third anodized layers underlie the first anodized layer in this order, the following refractive indices are obtained.

$$n_{av1} = 1.6 \times (1-0.33) + 1 \times 0.33 = 1.4$$

$$n_{av2} = 1.6 \times (1-0.42) + 1 \times 0.42 = 1.35$$

$$n_{av3} = 1.6 \times (1-0.33) + 1 \times 0.33 = 1.4$$

Here, in cases where light at a wavelength of 450 nm passes through the pore portion of the first anodized layer to enter the pore portions of the second and third anodized layers, when the waveform of light B which entered the pore portion of the third anodized layer, reflected on the bottom thereof and traveled on the optical path with a length of 2L and that of light A which reflected on the bottom of the second anodized layer overlap each other, the relation of formula (1) is met and reflection is enhanced.
Hence,

$$n_{av2}/n_{av3} = 1.35/1.4$$

$$L = 1/2 \times m \times 450 \times 1.35/1.4.$$

Reflection is enhanced at a depth L of 216 nm when m is 1 and at a depth L of 433 nm when m is 2.

The relation between the layer depth and the wavelength can be understood which causes enhanced reflection in the same manner as above as a result of overlapping of light which reflected on the bottom of the third anodized layer and passed through the third and second anodized layers with light which reflected on the bottom of the first anodized layer. The relation can also be understood which causes enhanced reflection in the same manner as above as a result of overlapping of light which reflected on the bottom of the second anodized layer with light which reflected on the bottom of the first anodized layer.

The mechanism of the enhanced light reflection is deemed to be interference or resonance of light reflected between different layers of the anodized film as described above, but is not limited to such a specific mechanism.

Depending on the anodizing treatment conditions, there are also cases where micropores whose average aperture size can be specified are formed and cases where alumina, aluminum hydroxide or a hydrous oxide thereof is randomly formed as a porous material and pores have no specific average aperture size. In the invention, the portion corresponding to such micropores are referred to as "pore portions." According to the finding by the inventors, it is considered that, even in such a case, the surface side layer p and the underlying Layer p+1 with a depth L included in at least two different layers cause light reflecting on the bottom of the pore portion of the surface side anodized layer p to interfere with light reflecting on the bottom of the pore portion of the layer p+1 other than the surface side layer to enhance the reflection at a wavelength λ of light for reflection. In the description of enhanced reflection, the depth L of a pore portion often refers to the actual vertical depth of the pore portion but may refer to the optical path length of light incident into the pore portion into the slightly oblique manner.

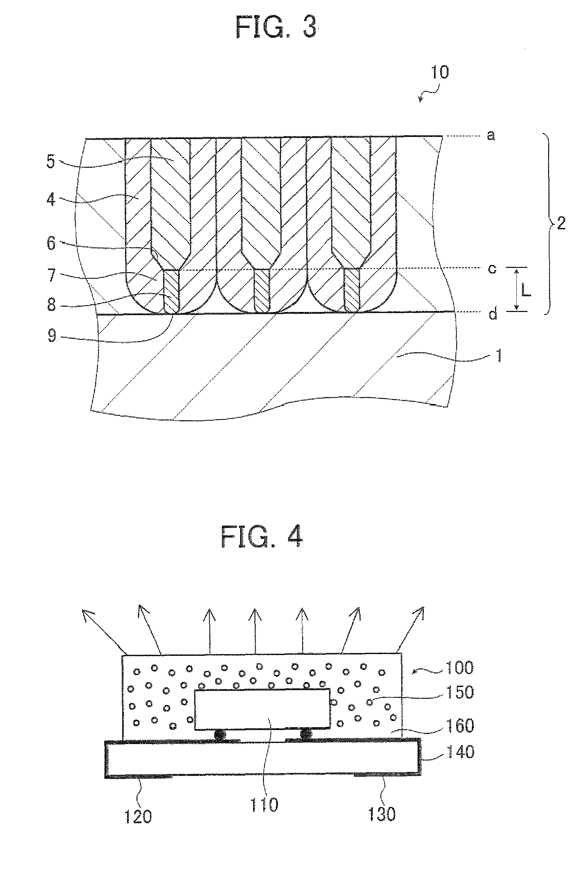

(1) The shape of the anodized layer is not particularly limited and the example shown in FIG. 3 is a characteristic shape. The anodized layer shown in the example of FIG. 3 is manufactured by a manufacturing method which involves forming the first anodized layer with a high porosity by the first anodizing treatment and performing the second anodizing treatment to reduce the aperture size of the micropores formed in the first anodized layer or fill the micropores so that the micropores may be porous.

FIG. 3 is a schematic cross-sectional view showing an embodiment of the radiation reflection plate which includes the anodized film-bearing aluminum alloy layer according to the invention.

A radiation reflection plate 10 shown in FIG. 3 is of a laminated structure in which an aluminum alloy layer 1 and an anodized film 2 of an aluminum alloy are stacked in this order. The position of the surface of the anodized film 2 is shown by line "a" and that of the interface between the aluminum alloy layer 1 and the anodized film is shown by line "d". The anodized layer p as the characteristic feature of the invention which is formed by the first Anodizing treatment and is shown by reference numeral 4 includes pore portions 5 corresponding to micropores extending from the surface "a" toward the aluminum alloy layer 1 side and bottoms 6. The position of the bottoms 6 is shown by a dotted line "c".

The anodized layer p+1 which is formed by the second anodizing treatment and is shown by reference numeral 7 includes pore portions 8 corresponding to micropores and bottoms 9. The anodized layers p and p+1 are formed by the different first and second anodizing treatments and the porosity $D_p$ of the layer having pore portions 5 is different from the porosity $D_{p+1}$ of the layer having pore portions 8. The bottom of the anodized layer p communicates with the anodized layer p+1 during the anodizing treatment, and the bottom 9 of the anodized layer p+1 is on the line "d" at an interface position between the aluminum alloy layer 1 and the anodized film 2. The vertical depth L of the anodized layer p+1 is a distance from "c" to "d". The term "communicate" as used herein refers to a state in which a fluid which may be a liquid or gas can flow.

The vertical depth (also referred to as "thickness") of the anodized layer p or p+1 is determined by taking a cross-sectional image of the anodized film 2 shown in FIG. 3 at a magnification of 150,000X, measuring the depth of at least 25 pore portions of the anodized layer and calculating the average of the resulting measurements.

3. [Porosity in cases in which the anodized layer includes pores having no specific aperture size]

There is also a case in which the anodized layer includes micropores having the same refractive index as that of air but in the case of a porous anodized layer including micropores whose refractive index is not the same as that of air, the porosities in the respective micropores can be measured. In the practice of the invention the porosity is determined as follows: A cross-sectional image of the anodized film 2 is taken at a magnification of 150,000X; voids are distinguished from portions containing alumina, hydrous aluminum oxide or the like on the image; their total areas are measured; the resulting values are converted into an assumable three-dimensional shape of the pore portions corresponding to the micropores to calculate the densities; and the porosity of the pore portions of the anodized layer is calculated based on the density of the pore portions of the void-free anodized layer which is represented by a porosity of 0%.

The shape of the pore portions corresponding to the micropores is not particularly limited and exemplary shapes include a substantially straight tubular shape (substantially columnar shape) and an octopus pot-like shape in which the diameter increases toward the depth direction and a substantially straight tubular shape is preferred.

When the ratio of the centerline length of the pore portion in the anodized layer to the depth of the pore portion in the anodized layer is from 1.0 to 1.2, incident light or reflected light linearly travels in the anodized layer at a high ratio and therefore the light reflectance is high.

The average aperture size of the portions corresponding to the micropores at the surface of the anodized film 2 is from about 10 nm to about 200 nm and preferably from 20 nm to 100 nm. The average aperture density is from about $1 \times 10^6$ to about $1 \times 10^{10}/mm^2$ At an average aperture density within the above-defined range, the light reflectance and the heat dissipation properties are excellent.

The depth (thickness) of the anodized film 2 is not particularly limited and is preferably from 1 to 200 $\mu$m in terms of more excellent insulating properties. A film depth of less than 1 $\mu$m reduces the withstand voltage due to poor insulating properties, whereas a film depth in excess of 200 $\mu$m requires a large amount of electrical power for manufacturing, which is economically disadvantageous. The anodized film preferably has a depth of 2 to 100 $\mu$m and more preferably 20 to 70 $\mu$m.

4. [Composition of aluminum alloy layer]

The aluminum alloy layer that may be used in the radiation reflection plate of the invention has an aluminum purity of at least 99.9 wt%, preferably at least 99.99 wt% and more preferably at least 99.991 wt%.

Inevitable impurities that cannot be avoided during the casting also adversely affect the light reflectance and withstand voltage. The light reflectance is high when the total amount of inevitable impurities is up to 0.05 wt%. Therefore, inevitable impurities including Si, Fe, Ga and Zn are incorporated in a total amount of up to 0.05 wt%.

In addition to silicon and iron, aluminum may contain other inevitable impurities such as copper, manganese, magnesium, chromium, bismuth, nickel and titanium.

The light reflectance can be improved by incorporating gallium (Ga) and zinc (Zn) in appropriate amounts. More specifically, it is desired to intentionally add Ga in an amount of 5 ppm to 25 ppm. It is desired to intentionally add Zn in an amount of 5 ppm to 20 ppm. An increase in the amount of addition adversely affects the withstand voltage and therefore the upper limits of the respective ingredients are limited.

In this specification, aluminum including the foregoing high-purity aluminum and aluminum alloys are collectively referred to as "aluminum alloys."

5. [Reflection plate having aluminum alloy layer (hereinafter sometimes referred to as "substrate"]

The aluminum alloy layer formed on a surface of a substrate made of other material should have a depth of at least 10 $\mu$m. The substrate made of other material may be one including an aluminum alloy layer. An anodized film may be separately manufactured and adhered to the aluminum alloy layer, but the surface of the aluminum alloy layer is preferably anodized to form an anodized film integrally.

The aluminum alloy layer may be optionally stacked on a metal sheet such as a steel sheet, a glass sheet, a ceramic sheet or a resin sheet. Alternatively, the aluminum alloy layer may be a single sheet.

The aluminum alloy layer in the form of a single aluminum alloy sheet preferably has a depth of about 0.1 mm to about 5 mm. The aluminum alloy sheet may be flat or have a recess for mounting a device such as a light-emitting device. The recess preferably has such a flared shape as to enlarge toward the upper side. This enables light emitted laterally from the light-emitting device mounted on the bottom of the recess to be reflected upward with high efficiency.

When the aluminum alloy layer is in the form of a single sheet, the anodized film may be formed on a front side main surface of the aluminum alloy plate or on the front side main surface and the back side main surface parallel to the front side main surface. The anodized film may optionally be formed on all of the six surfaces including four end surfaces.

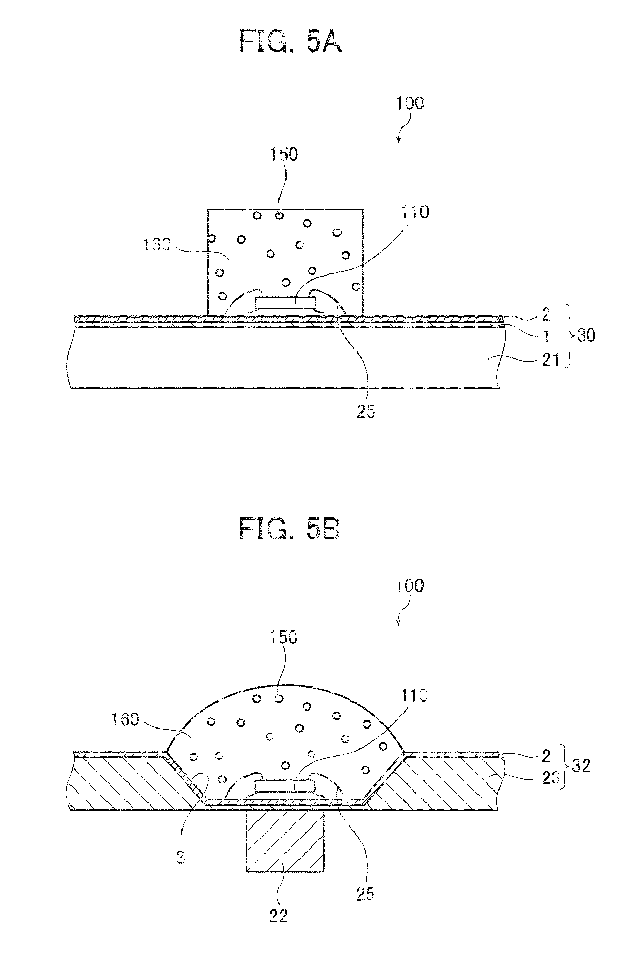

In cases where the aluminum alloy layer of the specific composition is stacked on another sheet and used, a radiation reflection plate 30 which is a plate having a heat-resistant flexible steel sheet or metal sheet 21 and the aluminum alloy layer stacked thereon as shown in FIG. 5A is preferred. FIG. 5A is a cross-sectional view illustrating a white light emitting unit 100 using the radiation reflection plate 30 according to an embodiment of the invention, the radiation reflection plate 30 including the metal sheet 21 and the aluminum alloy layer 1 which has the anodized film 2 bearing micropores of specific shapes. The laminated plate preferably has a thickness of about 0.1 mm to about 5 mm. The aluminum alloy layer 1 of the laminated plate which has the anodized film 2 and makes up the uppermost layer has a thickness of at least 10 $\mu$m, preferably 10 $\mu$m to 200 $\mu$m and more preferably 20 $\mu$m to 100 $\mu$m. The aluminum alloy layer may be formed only on one side or on both sides of the laminated plate.

In the case of lamination on a steel sheet, a hot-dip aluminum-coated steel sheet which has excellent adhesion between the aluminum alloy layer and the steel sheet and is obtained by hot dipping is preferred. A stainless steel sheet (SUS) is preferably used for the steel sheet.

In the case of lamination on a metal sheet, examples of the metal sheet preferably used for the lamination include an aluminum alloy sheet, a copper sheet, a nickel sheet and a titanium sheet, and an aluminum or aluminum alloy sheet and a nickel sheet are particularly preferred. The chemical and physical properties of the aluminum or aluminum alloy sheet are close to those of the aluminum alloy layer of the invention and therefore the aluminum or aluminum alloy sheet is preferable used for the laminate sheet. The aluminum alloy layer and the aluminum alloy sheet are preferably clad with a brazing filler metal for the lamination.

(1) Method of manufacturing hot-dip aluminum-coated steel sheet

An embodiment of the method of manufacturing a hot-dip alumium-coated steel sheet is described below.

A rolled stainless steel sheet is prepared and the Surface oxide film is removed. A reduction removal process in a reduction annealing furnace held in an oxygen-free state and a chemical removal process using acid pickling may be used to remove the oxide film. The stainless steel sheet just after the removal of the oxide film is immersed in an aluminum plating bath to form the aluminum alloy layer of the specific composition on the surface thereof. The thickness of the layer formed by plating varies with the viscosity of the molten aluminum and the surface properties of the steel sheet but a process of uniformizing the film thickness by a gas jet system may also be used. The sheet is then cooled to yield a plated steel sheet. The thickness of the plated film may be arbitrarily controlled in a range of about 10 $\mu$m to about 100 $\mu$m.

(2) Method of manufacturing aluminum clad material

An embodiment of the method of manufacturing an aluminum clad material is described below. An aluminum alloy for the skin material and an aluminum alloy for the brazing filler metal are subjected to casting, scalping and soaking by known methods to prepare an ingot for the skin material and an ingot for the brazing filler metal. The aluminum alloy for the skin material is used to form the aluminum alloy layer of the specific composition. The ingots are then rolled by hot rolling to predetermined thicknesses to prepare a rolled sheet for the skin material and that for the brazing filler metal.

On the other hand, an aluminum alloy for the core material is also subjected to casting, scalping and soaking by known methods to prepare an ingot for the core material.

Then, the ingot for the core material and the rolled sheet for the skin material are clad with the rolled sheet for the brazing filler metal, heat-treated at least 1 hour at a temperature of at least 450°C but up to 550°C, allowed to stand, and pressure-bonded by hot rolling in a stacked state to obtain an aluminum clad sheet. Then, cold rolling and intermediate annealing are performed to reduce the thickness to a predetermined value, and finally cold rolling is performed to obtain a finished sheet with a desired thickness,

Intermediate annealing is desirably performed at 350°C to 400°C for 2 to 4 hours. Final annealing may be performed to adjust the strength of the clad material after the final rolling in a range of 150 to 200 MPa. In this process, annealing may be performed at 150°C to 300°C for 1 to 3 hours.

(Brazing filler metal)

A commonly used brazing filler metal may be used to clad the aluminum alloy sheet and an Al-Si alloy brazing filler metal containing 7 to 13 wt% of Si is generally used. Preferred examples of the brazing filler metal include JIS4343, J134045 and JIS4047 alloys.

The brazing filler metal starts to melt at a temperature of up to 600°C and the molten metal as the liquid phase flows to contribute to joining the two aluminum alloy materials including the upper side skin material and the lower side core material. As will be described later, the melted ingredients of the brazing filler metal disperse in the aluminum materials on the upper and lower sides (skin material and core material) during heating. However, if the melted ingredients of the brazing filler metal disperse to the thickness of up to 10 $\mu$m and the skin material forming the aluminum alloy layer of the specific composition has a larger thickness than the desired thickness of the anodized film, the alloying ingredients of the brazing filler metal and the ingredients of inevitable impurities do not affect the aluminum alloy layer of the specific composition and therefore may not be taken into account.

(Core material)

A highly heat-resistant metal sheet may be used for the core material of the invention.

When the integral formability of the core material and the skin material making up the uppermost layer is taken into account, an aluminum alloy sheet or a stainless steel sheet is preferably used.

It is particularly preferred to use an aluminum alloy sheet as a material clad with a brazing filler metal.

Aluminum alloys such as JIS 3000 series and JIS 6000 series alloys may be used for the core material and it is particularly preferred to use JIS 6000 series alloys.

A stainless steel sheet is preferably used as a hot-dip aluminum-coated steel sheet having an aluminum layer formed on a steel sheet by hot-dip aluminum coating.

A conventionally known steel sheet may be used for the stainless steel sheet in this process. SUS403 and SUS304 materials are particularly preferred.

The laminated plate may be in the form of a flat plate or have a recess for mounting a device such as a light-emitting device. The substrate surface on which the aluminum alloy layer is to be laminated may be previously processed to form a recess or the substrate obtained after laminating the aluminum alloy layer of the specific composition may be processed. The recess preferably has such a flared shape as to enlarge toward the upper side. This enables light remitted laterally from the light-emitting device mounted on the bottom of the recess to be reflected upward with high efficiency.

The surface of the laminated plate is provided with the aluminum alloy layer, which has the anodized film having pore portions of a specific shape formed at the surface thereof.

6. [Surface treatments]

The surface treatments for manufacturing the radiation reflection plate of the invention may include various surface roughening treatments, pretreatments and post-treatments thereof, anodizing treatment, and various other treatment steps.

Typical methods for forming the above-described surface shape include a method in which an aluminum alloy sheet is subjected, in order, to alkali etching treatment, desmutting treatment using an acid and electrochemical graining treatment using an electrolytic solution, and a method in which alkali etching treatments, desmutting treatments using an acid and electrochemical graining treatments using different electrolytic solutions are performed on an aluminum alloy sheet. Mechanical graining treatment may further be performed prior to these surface roughening treatments.

A method using a nitric acid- and/or hydrochloric acid-based electrolytic solution is preferably used for the electrochemical graining treatment. Mechanical graining treatment may or may not be performed prior to these surface roughening treatments.

[Decreasing Treatment]

Degreasing treatment is carried out with a suitable substance such as an acid, alkali or organic solvent so as to dissolve and remove organic substances, including dust, grease and resins, adhering to the aluminum alloy substrate surface, and thereby prevent defects due to organic substances from arising in each of the subsequent treatments.

Preferred degreasing methods include the following: a method in which an organic solvent such as an alcohol (e.g., methanol), ketone (e.g., methyl ethyl ketone), petroleum benzin or volatile oil is contacted with the surface of the aluminum alloy substrate at ambient temperature (organic solvent method); a method in which a liquid containing a surfactant such as soap or a neutral detergent is contacted with the surface of the aluminum alloy substrate at a temperature of from ambient temperature to 80°C, after which the surface is rinsed with water (surfactant method); a method in which an aqueous sulfuric acid solution having a concentration of 10 to 200 g/L is contacted with the surface of the aluminum alloy substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum alloy substrate at ambient temperature for about 30 seconds while electrolysis is carried out by passing a direct current through the aluminum alloy substrate surface as the cathode at a current density of 1 to 10 A/dm$^2$, following which the surface is contacted with an aqueous solution of nitric acid having a concentration of 100 to 500 g/L and thereby neutralized; a method in which any of various known anodizing electrolytic solutions is contacted with the surface of the aluminum alloy substrate at ambient temperature while electrolysis is carried out by passing a direct current at a current density of 1 to 10 A/dm$^2$ through the aluminum alloy substrate surface as the cathode or by passing an alternating current through the aluminum alloy substrate surface as the cathode; a method in which an aqueous alkali solution having a concentration of 10 to 200 g/L is contacted with the surface of the aluminum alloy substrate at 40 to 50°C for 15 to 60 seconds, following which the surface is contacted with an aqueous solution of nitric acid having a concentration of 100 to 500 g/L and thereby neutralized; a method in which an emulsion prepared by mixing a surfactant, water and the like into an oil such as gas oil or kerosene is contacted with the surface of the aluminum alloy substrate at a temperature of from ambient temperature to 50 °C, following which the surface is rinsed with water (emulsion degreasing method); and a method in which a mixed solution of, for example, sodium carbonate, phosphates and surfactant is contacted with the surface of the aluminum alloy substrate at a temperature of from ambient temperature to 50°C for 30 to 180 seconds, following which the surface is rinsed with water (phosphate method).

Of these, the organic solvent method, surfactant method, emulsion degreasing method and phosphate method are preferred from the standpoint of removing grease from the aluminum alloy surface while causing substantially no aluminum alloy dissolution.

Known degreasers may be used in decreasing treatment. For example, degreasing treatment may be carried out using any of various commercially available degreasers by the prescribed method.

7. [Through-hole formation and routing]

In the radiation reflection plate of the invention, through-hole formation for appropriately providing an interconnect portion and routing for a system on a chip assuming a final product may also be performed prior to mounting the light-emitting device. Through-hole formation may be preceded or followed by surface treatment and anodizing treatment step. Such processing before the formation of the insulating layer through anodization to be described later can prevent the insulating layer formed by anodization to be cracked while holding the insulating properties of the end surfaces of the substrate formed by the processing. When performed after the anodizing treatment step, these processing steps increase the efficiency of the anodizing treatment step and the anodized film can be precisely processed to a size of the final product.

Examples of the method suitable to the through-hole formation and routing include drilling, press working using a die, dicing using a dicing saw and laser processing but the method is not limited thereto.

8. [First anodizing treatment step]

The first anodizing treatment step is a step for anodizing the aluminum alloy layer to form an aluminum oxide film having micropores or pore portions extending in the depth direction (thickness direction) at the surface of the aluminum alloy layer. As shown in FIG. 3, as a result of the first anodizing treatment, the anodized aluminum film 2 bearing micropores or pore portions is formed at a surface of the aluminum alloy layer 1.

The first anodizing treatment may be performed by a conventionally known method in the art but the manufacturing conditions are appropriately set so that the foregoing micropores or pore portions may be finally formed.

More specifically, the micropores formed in the first anodizing treatment step usually have an average diameter (average aperture size) of about 10 to about 200 nm and preferably 20 to 100 nm. At an average diameter within the above-defined range, the light reflectance and the heat dissipation properties are excellent.

If necessary, not only the main flat surfaces of the aluminum alloy sheet but also the interior of the through holes and the end faces of the aluminum alloy layer may be anodized to impart the insulating properties and the light reflectivity.

The solution that may be used in the first anodizing treatment step may contain acids such as sulfuric acid, phosphoric acid, chromic acid, oxalic acid, sulfamic acid, benzenesulfonic acid, amidosulfonic acid, malonic acid, citric acid, tartaric acid and boric acid, and hydroxides of alkali metals and alkaline-earth metals such as sodium hydroxide, magnesium hydroxide, potassium hydroxide, and calcium hydroxide. The acids and hydroxides may be used singly or in combination of two or more in the form of aqueous solution.

The self-ordering method and constant voltage treatment described in paragraphs [0055] to [0108] of JP 2008-270158 A may be used in order to control the anodizing treatment conditions so as to have micropores of a specific shape.

It is acceptable for at least ingredients ordinarily present in the aluminum alloy layer, electrodes, tap water, ground water and the like to be present in the electrolytic solution. In addition, secondary and tertiary ingredients may be added. Here, "secondary and tertiary ingredients" includes, for example, the ions of metals such as sodium, potassium, magnesium, lithium, calcium, titanium, aluminum, vanadium, chromium, manganese, iron, cobalt, nickel, copper and zinc; cations such as ammonium ion; and amnions such as nitrate ion, carbonate ion, chloride ion, phosphate ion, fluoride ion, sulfite ion, titanate ion, silicate ion and borate ion. These may be present in concentrations of about 0 to 10,000 ppm.

The anodizing treatment conditions vary empirically according to the electrolytic solution used, although it is generally suitable for the solution to have an electrolyte concentration of 1 to 80 wt% and a temperature of 5 to 70°C, and for the current density to be 0.5 to 60 A/dm$^2$, the voltage to be 1 to 600 V, and the electrolysis time to be 15 seconds to 20 minutes. These conditions may be adjusted to obtain the desired anodized layer weight.

Methods that may be used to carry out anodizing treatment include those described in JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A and JP 5-195291 A.

Of these, as described in JP 54-12853 A and JP 48-45303 A, it is preferable to use a sulfuric acid solution as the electrolytic solution. The electrolytic solution has a sulfuric acid concentration of preferably 10 to 300 g/L, and has an aluminum ion concentration of preferably 1 to 25 g/L, and more preferably 2 to 10 g/L. Such an electrolytic solution can be prepared by adding a compound such as aluminum sulfate to dilute sulfuric acid having a sulfuric acid concentration of 50 to 200 g/L.

when anodizing treatment is carried out in an electrolytic solution containing sulfuric acid, direct current or alternating current may be applied across the aluminum alloy sheet and the counter electrode. In cases where a direct current is applied to the aluminum alloy sheet, it is desired to apply a constant voltage across the aluminum sheet and the counter electrode and it is desired to apply a voltage in a range of 10V to 50V.

The anodized film has micropores in the depth direction from the surface of the anodized film and the ratio of the centerline length to the depth of the micropores (length/depth) is preferably from 1.0 to 1.2, more preferably from 1.0 to 1.1 and even more preferably from 1.0 to 1.05. When the micropores have such a shape as to meet the foregoing range, the resulting radiation reflection plate has high insulating properties and high light reflectance. When the ratio of the centerline length to the depth of the pore portions corresponding to the micropores with a depth L is in the above-defined range, the resulting light reflectance at specific wavelengths is high.

The thickness of the anodized film is preferably 1 to 200 $\mu$m. A film thickness of less than 1 $\mu$m reduces the withstand voltage due to poor insulating properties, whereas a film thickness in excess of 200 $\mu$m requires a large amount of electrical power, which is economically disadvantageous. The anodized film has a thickness of more preferably 2 to 100 $\mu$m and even more preferably 20 to 70 $\mu$m.

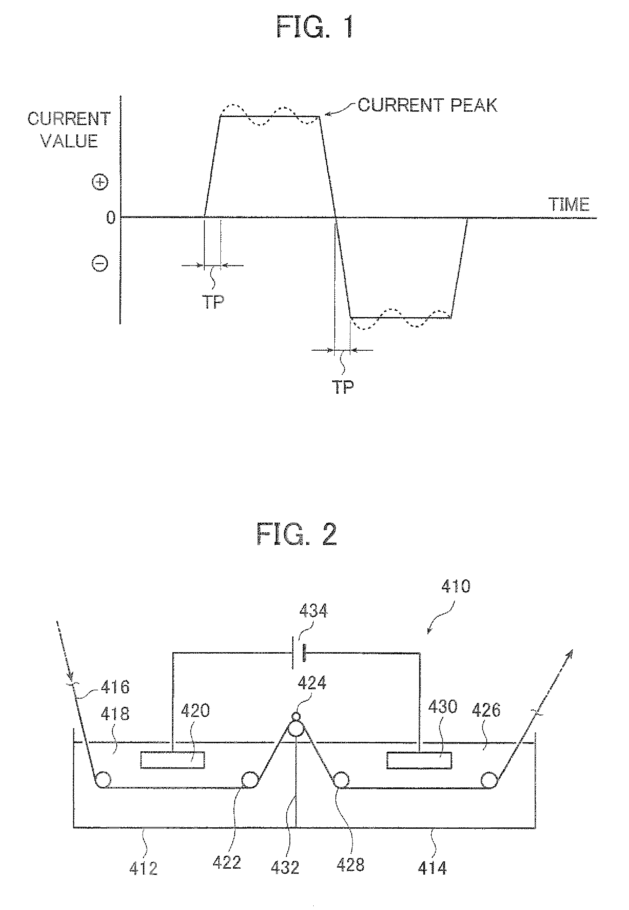

Examples of electrolysis apparatuses that may be used in anodizing treatment include those described in JP 48-26638 A, JP 47-18739 A and JP 58-24517 B. An apparatus shown in FIG. 2 is particularly used with advantage. FIG. 2 is a schematic view showing the apparatus for anodizing the surface of an aluminum sheet. In an anodizing apparatus 410, an aluminum sheet 416 is transported as shown by arrows in FIG. 2. The aluminum sheet 416 is positively (+) charged by a power supply electrode 420 in a power supply cell 412 containing an electrolytic solution 418. The aluminum sheet 416 is then transported upward by a roller 422 disposed in the power supply cell 412, turned downward on a nip roller 424 and transported toward an electrolytic cell 414 containing an electrolytic solution 426 to be turned to a horizontal direction by a roller 428. Then, the aluminum sheet 416 is negatively (-) charged by an electrolytic electrode 430 to form an anodized film on the sheet surface. The aluminum sheet 416 emerging from the electrolytic cell 414 is then transported to the section for the subsequent step. In the anodizing apparatus 410, the roller 422, the nip roller 424 and the roller 428 constitute direction changing means, and the aluminum sheet 416 is transported through the power supply cell 412 and the electrolytic cell 414 in a mountain shape and a reversed U shape by means of these rollers 422, 424 and 428. The power supply electrode 420 and the electrolytic electrode 430 are connected to a DC power supply 434.

9. [Second anodizing treatment step]

In the second anodizing treatment step, the aluminum alloy layer having undergone the first anodizing treatment is anodized under different conditions from these in the first anodizing treatment to form two different anodized layers. The second anodizing treatment step may be a step for forming pore portions corresponding to the micropores and extending in the depth direction (thickness direction) more than in the first anodizing treatment or a step in which the pore portions corresponding to the micropores hardly grow in the depth direction and the aperture diameter of the micropores is reduced in the radial direction. The step of oxidizing the aluminum alloy layer having no apertures of the micropores may be applied. As shown in FIG. 3, the second anodizing treatment step forms the anodized film 2 having the pore portions 5 formed by the first anodizing treatment step and the pore portions 8 further extending in the depth direction (thickness direction).

The anodizing treatment steps may be performed under different conditions, that is, under the first, second, third, ... and nth conditions. The resulting anodized film may be of a multilayer structure having any number of anodized layers. The conditions may be different in the type of electrolytic cell, and the conditions such as the voltage applied and the current density may be changed. The electrolytic cells used in the respective anodizing treatment steps are the same as used in the first anodizing treatment step and the treatment conditions are appropriately set according to the resulting anodized layer.

A preferred example of the combined method include one in which the surface of the aluminum alloy layer is subjected to the first anodizing treatment in an aqueous sulfuric acid solution and is then subjected to the second anodizing treatment in an aqueous boric acid solution. Another example is one in which the surface of the aluminum alloy layer is subjected to the first anodizing treatment in an aqueous sulfuric acid solution and is then subjected to the second anodizing treatment in an aqueous phosphoric acid solution.

[Sealing treatment]

In the practice of the invention, if necessary, sealing treatment may be performed to close the micropores present in the porous anodized film. Sealing treatment may be performed in accordance with a known method, such as boiling water treatment, hot water treatment, steam treatment, sodium silicate treatment, nitrite treatment or ammonium acetate treatment. For example, sealing treatment may be performed using the apparatuses and processes described in JP 56-12518 B, JP 4-4194 A, JP 5-202496 A and JP 5-179482 A.

[Acid or alkali etching treatment]

An aqueous acid or alkali solution may optionally be used to perform surface cleaning treatment.

[Rinsing with water]

Rinsing with water is preferably performed after the end of the foregoing treatments. Examples of the water used for rinsing include pure water, well water and tap water. A nip device may be used to prevent the treatment solution from being carried into the subsequent step. After rinsing with water, the anodized film may be further immersed in an acid or alkali solution for 1 to 60 seconds and ringed with water.

[Protective layer]

The radiation reflection plate of the invention may be subjected to a protective treatment against various solvents used in the posttreatments to be described later including formation of a metal interconnect layer for transmitting electric signals to the LED, patterning and formation of a metal layer in the LED mounting area.

More specifically, in the protective treatment, the surface properties of the anodized film including hydrophilicity and hydrophobicity (lipophilicity and lipophobicity) can be appropriately changed as described in, for example, JP 2008-93652 A and JP 2009-65076 A. In addition, a method of imparting the resistance to acids and alkalis may also be appropriately used.

10. [Interconnect layer]

The interconnect layer made of a metal conductor (metal interconnect layer) according to the invention is described below in detail.

The interconnect layer of the invention is formed on the anodized film of the above-described radiation reflection plate of the invention and used to mount the light-emitting device. The interconnect layer may be formed on the anodized film on which the light-emitting device is to be mounted. Alternatively, the interconnect layer may be formed on the back side opposite from the anodized film on which the light-emitting device is to be mounted, and be electrically connected via a through-hole to the side on which the light-emitting device is to be mounted.

The material of the metal interconnect layer is not particularly limited as long as it is an electrically conductive material, and specific examples thereof include gold (Au), silver (Ag), copper (Cu), aluminum (Al), magnesium (Mg) and nickel (Ni). These may be used singly or in combination of two or more thereof.

Of these, copper is preferably used because of its low electric resistance. A gold layer or a nickel/gold layer may be formed on top of the copper interconnect layer in order to enhance the ease of wire bonding.

In terms of conduction reliability and packaging compactness, the metal interconnect layer preferably has a thickness of 0.5 to 1,000 μm, more preferably 1 to 500 μm and most preferably 5 to 250 μm.

Exemplary methods of forming the metal interconnect layer include various plating treatments such as electrolytic plating, electroless plating and displacement plating, sputtering, vapor deposition, vacuum application of metal foil and adhesion using an adhesive layer.

Of these, it is preferred to form the layer only using metal in terms of its high heat resistance and it is particularly preferred to form the layer by plating in terms of forming a thick and uniform film and high adhesion.

The anodized film is subjected to the plating treatment and therefore a process in which a reduced metal layer called "seed layer" is formed and the thus formed metal layer is used to form a thick metal layer is preferably used.

Electroless plating is preferably used to form the seed layer and a solution containing main ingredients (e.g., metal salt and reducing agent) and auxiliary ingredients (e.g., pH adjuster, buffer, complexing agent, promoter, stabilizer and improver) is preferably used for the plating solution. Commercial products such as SE-650-666-680, SEK-670·797, SFK-63 (available from Japan Kanigen Co., Ltd.) and Melplate NI-4128, Enplate NI-433, Enplate NI-411 (available from Meltex Inc.) may be appropriately used for the plating solution.

In the case of using copper as a material of the metal interconnect layer, use may be made of various electrolytic solutions containing sulfuric acid, copper sulfate, hydrochloric acid, polyethylene glycol and a surfactant as the main ingredients and various other additives.

The thus formed metal interconnect layer is patterned by any known method according to the LED mounting design. A metal layer (including a solder) may be formed again in the portion where the LED is to be actually mounted, and appropriately processed by thermocompression bonding, flip-chip bonding or wire bonding for easier connection.

The suitable metal layer is preferably made of metal materials such as solder, gold (Au), silver (Ag), copper (Cu), aluminum (Al), magnesium (Mg) and nickel (Ni). In terms of the LED mounting under heating, a method of applying gold or silver through nickel is preferred for the connection reliability.

Formation of a pattern on the anodized film by an interconnect layer-forming method such as inkjet printing or screen printing using a metal ink to be described later enables a patterned interconnect layer to be simply formed on a roughened surface without requiring a large number of steps. The adhesion between the interconnect layer and the light reflection layer is also excellent owing to the high anchor effect produced by the micropores of the anodized film.

(Inkjet printing)

The interconnect layer is formed on a desired portion of the anodized film by inkjet printing using a metal ink containing a conductor metal. The metal ink is used to form an interconnect pattern, which is then fired to obtain an interconnect.

An example of the metal ink include one which is obtained by uniformly dispersing a particulate conductor metal in a solvent containing, for example, a binder and a surfactant. In this case, the solvent should have affinity for the conductor metal and volatility.

Examples of the conductor metal contained in the metal ink include microparticles of metals such as silver, copper, gold, platinum, nickel, aluminum, iron, palladium, chromium, molybdenum and tungsten; microparticles of metal oxides such as silver oxide, cobalt oxide, iron oxide and ruthenium oxide; microparticles of composite alloys such as Cr-Co-Mn-Fe, Cr-Cu, Cr-Cu-Mn, Mn-Fe-Cu, Cr-Co-Fe, Co-Mn-Fe and Co-Ni-Cr-Fe; and microparticles of composites obtained by plating with silver or copper. These may be used singly or in combination of two or more thereof.

Of these, metal microparticles are preferred and silver, copper and gold are more preferred. Silver is particularly preferred because of the excellent oxidation resistance, high resistance to generation of highly insulating oxides, low cost and improved conductivity after the firing of the interconnect pattern.

The shape of the particulate conductor metal is not particularly limited and examples thereof include a spherical shape, a granular shape and a scale-like shape. The scale-like shape is preferred in terms of improving the electrical conductivity by increasing the contact area between the microparticles.

In terms of improving the electrical conductivity by increasing the filling ratio in the interconnect pattern formed with the metal ink and supplying the anodized film on the substrate of the invention with the metal ink, the conductor metal contained in the metal ink has an average size of preferably 1 to 20 nm and more preferably 5 to 10 nm.

(Screen printing)

The conductor metal-containing metal ink is printed on a desired portion of the anodized film by screen printing. The metal ink is used to form an interconnect pattern, which is then fired to obtain an interconnect.

In the screen printing, the metal ink is supplied by forming permeable portions corresponding to an interconnect pattern in a screen and squeezing the metal ink through the permeable portions.

Conductor metal-containing metal inks used in the above-described inkjet printing may be employed.

11. [Application of radiation reflection plate]

The radiation reflection plate of the invention may be widely used for light-emitting devices. The radiation reflection plate of the invention is particularly suitable for use in LEDs. The radiation reflection plate may be used in various applications without particular limitation irrespective of the type and shape of LED used. The radiation reflection plate of the invention may be used, for example, for LED packages using conventionally known LEDs.

The reflection light at specific wavelengths can be enhanced to improve the luminance in a light-emitting unit 100, for example, by replacing a substrate 140 shown in FIG. 4 by the radiation reflection plate 30 of the invention. FIG. 4 shows a white LED fluorescent unit (LED package) 100. An LED 110 such as a blue LED is face-down-bonded to the substrate 140 having electrodes 120 and 130 for external connection and the blue LED 110 is molded with a transparent resin 160 containing YAG fluorescent particles 150. Light excited by the YAG fluorescent particles 150 and afterglow of the blue LED 110 cause the white LED fluorescent unit 100 to emit white light in directions shown by arrows on the light-emitting surface side.

Use may be made of a fluorescent device of such a configuration that a blue LED is provided on the radiation reflection plate of the invention and sealed with a known resin, and a microstructure (fluorescent unit) which is an anodized layer of a valve metal filled with a fluorescent emitter is provided above the blue LED. The fluorescent devices are described in JP 2010-283057 A and JP 2010-285640 A.

FIG. 5A shows the radiation reflection plate 30 of the invention which includes a core such as an SUS metal sheet 21 and the aluminum alloy layer 1 which is formed on a surface of the metal sheet 21 and hat the anodized film 2 formed at the surface thereof. FIG. 5A also shows in cross-section the fluorescent unit 100 in which the LED 110 disposed on the radiation reflection plate 30 is sealed with a transparent resin 160 containing the fluorescent particles 150. The metal sheet 21 serves as the core which contributes to the mechanical strength and flexibility of the radiation reflection plate of the invention. The metal sheet 21 may serve as a heat sink to contribute to the heat dissipation properties. The LED 110 is bonded with wires 25 to be electrically connected to necessary portions of an interconnect layer (not shown) formed on the anodized layer 2.

FIG. 5B shows in cross-section an application of the radiation reflection plate 32 of the invention which includes an aluminum alloy sheet 23 and the anodized film 2 formed at a surface thereof. FIG. 5B also shows the fluorescent unit 100 in which the LED 110 disposed on the radiation reflection plate 32 is sealed with the transparent resin 160 containing the fluorescent particles 150.

Part of the aluminum alloy sheet 23 on which the LED 110 is to be mounted has a recess 3 whose lateral face is slanted so that the recess 3 is outwardly enlarged toward the upper side. The LED 110 is disposed on the radiation reflection plate 32 by die bonding and a heat sink 22 may be provided under the radiation reflection plate 32. The LED 110 is bonded with wires 25 to be electrically connected to necessary portions of an interconnect layer (not shown) formed on the anodized layer 2. The radiation reflection plate 32 of the invention has high insulating properties and a high total reflectivity at a desired specific wavelength and the light-emitting unit 100 (LED package) in which the radiation reflection plate 32 is used as the substrate has therefore high luminous efficiency.

This light-emitting device which includes a light-emitting layer of a semiconductor such as GaAlN, ZnS, ZnSe, SiC, GaP, GaAlAs, AlN, InN, AlInGaP, InGaN, GaN or AlInGaN formed on the substrate is used. The semiconductor is, for example, of a homostructure, heterostructure or double heterostructure having an MIS junction, PIN junction or PN junction. The light-emitting wavelength may be variously selected in a range of ultraviolet light to infrared light depending on the material of the semiconductor layer and the mixture ratio thereof.

The transparent resin 160 is preferably a thermosetting resin. The transparent resin 160 is preferably made of at least one selected from the group consisting of themosetting resins such as epoxy resin, modified epoxy resin, silicone resin, modified silicone resin, acrylate resin, urethane resin and polyimide resin. Epoxy resin, modified epoxy resin, silicone resin and modified silicone resin are particularly preferred. The transparent resin 160 is preferably hard in order to protect the LED 110. A resin having excellent heat resistance, weather resistance and light resistance is preferably used for the transparent resin 160. At least one selected from the group consisting of filler, diffusing agent, pigment, fluorescent material, reflective material, UV absorber and antioxidant may also be mixed into the transparent resin 160 to impart predetermined functions thereto.

The fluorescent particles 150 used should be of a type capable of wavelength conversion of light absorbed from the light-emitting device 30 to change the wavelength of the light. The fluorescent particles 150 are preferably made of at least one selected from the group consisting of nitride phosphors, oxynitride phosphors, SiAlON phosphors and β-SiAlON phosphors mainly activated by lanthanoid elements such as Eu and Ce; alkaline-earth halogen apatite phosphors mainly activated by lanthanoid elements such as Eu and transition metal elements such as Mn; alkaline-earth metal borate halogen phosphors; alkaline-earth metal aluminate phosphors; alkaline-earth silicate phosphors; alkaline-earth sulfide phosphors; alkaline-earth thiogallate phosphors; alkaline-earth silicon nitride phosphors; germanate phosphorus;

rare-earth aluminate phosphors mainly activated by lanthanoid elements such as Ce; rare-earth silicate phosphors; and organic compounds and organic complexes mainly activated by lanthanoid elements such as Eu.

As described above, the radiation reflection plate of the invention may also be used as a radiation reflection plate of a phosphor color mixed type white LED light-emitting device which uses a UV to blue LED and a fluorescent emitter which absorbs light from the UV to blue LED and emits fluorescence in a visible light region.

The fluorescent emitter absorbs blue light from the blue LED to emit fluorescence (yellow fluorescence) and the fluorescence and afterglow of the blue LED cause the light-emitting device to emit white light.

This is of a so-called "pseudo-white light-emitting type" which uses a blue LED chip as the light source and a yellow phosphor in combination. The radiation reflection plate of the invention may be used in the substrate of the light-emitting device in a light-emitting unit which uses other known light-emitting systems such as "UV to near-UV light source type" which uses a UV to near-UV LED chip as the light source and several types of red/green/blue phosphors in combination, and "RGB light source type" which emits white light from the three light sources of red, green and blue colors.

The method of mounting the light-emitting device on the interconnect layer of the invention involves heating, and in the mounting method involving thermocompression bonding including reflow soldering and flip chip bonding, the maximum temperature reached is preferably from 220°C to 350°C, more preferably from 240°C to 320°C and most preferably from 260°C to 300°C in terms of uniform and reliable mounting. The maximum temperature reached is preferably kept for 2 seconds to 10 minutes, more preferably from 5 seconds to 5 minutes and most preferably from 10 seconds to 3 minutes for the same reason as above.

In order to prevent cracks from occurring in the anodized layer during the thermal treatment due to a difference in the coefficient of thermal expansion between the aluminum alloy layer and the anodized layer in the substrate of the invention, a heat treatment may also be performed before reaching the maximum temperature at a desired constant temperature for preferably 5 seconds to 10 minutes, more preferably 10 seconds to 5 minutes and most preferably 20 seconds to 3 minutes. In this case, the desired constant temperature is preferably from 80°C to 200°C, more preferably from 100°C to 180°C and most preferably from 120°C to 160°C. At treatment temperature and time of less than the defined ranges, the light-emitting device may not be satisfactorily mounted, whereas at treatment temperature and time exceeding the defined ranges, the substrate may deteriorate.

The light-emitting device is mounted by wire bonding at a temperature of preferably 80°C to 300°C, more preferably 90°C to 250°C and most preferably 100°C to 200°C in terms of reliable mounting also in the case. The heating time is preferably 2 seconds to 10 minutes, more preferably 5 seconds to 5 minutes and most preferably 10 seconds to 3 minutes.

EXAMPLES

The present invention is described below more specifically by way of examples. However, the present invention should not be construed as being limited to the following examples.

(Examples 1 to 20 and Comparative Examples 1 to 5)

1. [Preparation of radiation reflection plate made of aluminum alloy]

[Substrate 1: 99.99% aluminum alloy rolled sheet]

The surfaces of an ingot of high-purity aluminum (99.99 wt%) were scalped to a depth of 1 cm to remove non-uniform surface portions.

Then, the ingot was rolled six times in a cold rolling machine at a draft per pass of 50% and finally rolled to a final sheet thickness of 0.8 mm.

A sheet portion with a size of 10 cm × 15 cm was cut from the rolled sheet and surface-treated to prepare a substrate sample for evaluation.

[Substrate 2: aluminum clad material]

An aluminum alloy prepared in the same manner as Substrate 1 was rolled to a thickness of 0.8 mm and used as the skin material. The skin material was clad with an ingot having an aluminum purity of 99.9 wt% via a brazing filler metal and the clad metal was heat-treated in a furnace at 500°C for 3 hours and hot-rolled to prepare a sheet material. The sheet material was further cold-rolled five times at a draft of 30% and then subjected to 3-hour intermediate annealing at 350°C and cold rolling to obtain a rolled sheet with a final thickness of 0.3 mm. The ingredient analysis of the rolled sheet in its depth direction by GD-ICP confirmed that the aluminum alloy ingredients of Substrate 1 were kept to a depth from the surface layer of 80 μm in the form of an aluminum alloy layer. A layer of higher silicon concentration due to the brazing filler metal was observed in the portion with a depth of at least 80 μm and the portion with a depth from the surface of at least 100 μm contained the ingredients of a 3N(99.9%) aluminum alloy material.

[Substrate 3: hot-dip aluminum-coated material]

A stainless steel sheet SUS 403 2B with a thickness of 0.3 mm was prepared. The prepared stainless steel sheet was treated for 3 minutes with 10% aqueous solution of ferric chloride (40°C) to roughen the sheet surface and the treated sheet was used.

The aluminum alloy of Substrate 1 was melted in a furnace and the foregoing stainless steel sheet was immersed in the melted aluminum alloy to form an aluminum skin layer with a thickness of about 100 μm. This substrate was called Substrate 3.

The composition analysis revealed that the transition regions of the aluminum layer and the stainless steel layer where iron as the main ingredient of stainless steel was dispersed each had a thickness of about 50 μm. It could be deduced that the aluminum alloy ingredients making up the skin material were kept to a depth from the surface layer of 50 μm.

Substrates 1, 2 and 3 were degreased and treatment (a) or (b) was performed prior to anodizing treatment. Following completion of each treatment and rinsing treatment, the remaining solution or water was removed with nip rollers.

1. Degreasing treatment

Degreasing treatment was performed as follows: a solution containing a surfactant was brought into contact with the surface of the aluminum sheet and rinsed with water, Then, the surface of the aluminum sheet was dissolved by contact with an aqueous solution having a sulfuric acid concentration of 15 g/L, which was followed by rinsing with water.

2. Treatment prior to anodizing treatment

(a) Method of manufacturing mirror-finished aluminum sheet

The aluminum sheet was immersed in an electrolytic solution having a phosphoric acid concentration of 30 wt%, subjected to electrolytic polishing for 30 seconds under the application of 30 V voltage, rinsed with water and dried.

(b) Method of manufacturing roughened aluminum sheet

An electrolytic solution containing 10 g/L of nitric acid and 4.5 g/L of aluminum nitrate was prepared and kept at a temperature of 45°C. The sheet was immersed in the electrolytic solution. A carbon electrode was used as the counter electrode and an alternating current of the waveform shown in FIG. 1 was applied to perform electrolytic graining treatment for 10 seconds. After rinsing with water, the sheet was immersed in an aqueous sodium hydroxide solution to dissolve 5 g/m$^2$ of surface portion thereof. The sheet was further rinsed with water, neutralized in sulfuric acid, rinsed with water and dried. Then, the electrolytic polishing described in (a) was performed.

3. Anodizing treatment

An anodizing apparatus of the configuration shown in FIG. 2 was used to anodize the substrates obtained as above. The first anodizing treatment, the second anodizing treatment and optionally the third anodizing treatment as shown in Step 1, Step 2 and Step 3 in Table 1 were performed under the following anodizing treatment conditions (1) to (3) to obtain anodized layers shown in Layers 1, 2 and 3 of Table 2. Table 1 shows the acids used in the following anodizing treatment steps.

(1) Anodizing treatment using sulfuric acid

The anodizing treatment step was performed by DC electrolysis at a voltage of 25 V in an aqueous solution containing 35 g/L of sulfuric acid at a temperature of 15°C. The treatment time was adjusted so as to form the anodized layer with a predetermined depth shown in Table 1.

(2) Anodizing treatment using boric acid

The anodizing treatment step was performed by DC electrolysis at a voltage of 300 V in an aqueous solution containing 30 g/L of boric acid and 20 g/L of sodium borate at a temperature of 20°C. The treatment time was adjusted so as to form the anodized layer with a predetermined depth shown in Table 1.

(3) Anodizing treatment using phosphoric acid

The anodizing treatment step was performed by DC electrolysis at a voltage of 500 V in an aqueous solution containing 1 g/L of phosphoric acid at a temperature of 5°C. The treatment time was adjusted so as to form the anodized layer with a predetermined depth shown in Table 1.

4. Sealing treatment

The anodized substrates shown in Table 1 were rinsed with water and immersed in pure water at 80°C for 20 minutes. In
Table 1, the term "unperformed" indicates that the substrate did not undergo this treatment.

5. Acid treatment

The sealed substrates shown in Table 1 were immersed in an aqueous solution containing 100 g/L of sulfuric acid at room temperature for 30 seconds.
In Table 1, the term "Unperformed" indicates that the substrate did not undergo this treatment.

(Example 21)

Gold nanoparticles (NanoTek available from C. I. Kasei Co., Ltd.; 50 g) were added to 50 g of xylene and the mixture was stirred at room temperature for 8 hours to obtain an stabilized gold ink dispersion. The solid powder analysis of the ink dispersion revealed that the gold content was 26.8 wt%. A silane coupling agent KBM603 (Shin-Etsu Polymer Co., Ltd.) was further added to the ink dispersion in an amount of 2 wt% with respect to the ink dispersion and the mixture was stirred to prepare a metal ink. The prepared metal ink had a viscosity of 10 cps.
Then, a Dimatix Material Printer DMP-2831 (FUJIFILM Dimatix, Inc.) was used to apply the prepared metal ink by inkjet printing onto the surface of the anodized film in the radiation reflection plate which was the substrate obtained in Example 1, and the metal ink was hot-air dried in a hot air dryer set at 160°C for about 5 minutes to obtain a gold metal interconnect.

6. [Determination of radiation reflection plate]

(1) Depth of anodized layer

The vertical depth (hereinafter also referred to simply as "depth") of the anodized layer is determined by taking a cross-sectional image of the anodized film at a magnification of 150,000X, measuring the depth of at least 25 pore portions of the anodized layer corresponding to the micropores and calculating the average of the resulting measurements.

(2) Determination of porosity

The porosity is determined as follows: A cross-sectional image of the anodized film is taken at a magnification of 150,000X; voids in the pore portions are distinguished from portions made of alumina or hydrous aluminum oxide in the pore portions on the image; their total areas are measured; the resulting values are converted into an assumable three-dimensional shape of the micropores to calculate the densities; and the porosity of the pore portions of the anodized layer is calculated based on the porosity of 0% which refers to the case where the pore portions have no void and the porosity of 100% which refers to the case where the pore portions are completely hollow, i.e., the case of micropores. Measurement was made for at least 25 pore portions and the average of the measurements was shown in Table 2.
In Example 16, the first anodizing treatment was followed by sealing treatment and acid treatment to adjust the porosity to 0% for the pore portions corresponding to the micropores. The layer obtained by the subsequent sealing treatment and acid treatment is positioned on the surface side and therefore Layer 1 and Layer 2 whose porosities are shown in Table 2 refer to the layer obtained by the subsequent treatments and that obtained by anodizing treatment, respectively.

(3) Determination of ratio of centerline length to depth of anodized layer with depth T (length/depth)

The cross-sectional surface of the anodized layer in which pore portions having a depth T were formed was observed by FE-SEM (S-4000 manufactured by Hitachi, Ltd.). The ratio of the centerline length to the depth of the anodized layer (length/depth) was measured and the average of the measurements was calculated. As a result, the ratio was in a range of 1.01 to 1.20 in all of Examples 1 to 20.

(4) Determination of light reflectance

The reflectance (total amount of reflected light/incident light $\times$ 100) of the radiation reflection plates for use in LEDs as obtained in Examples and Comparative Examples at wavelengths of 450 nm and 350 nm was determined by X-Rite (X-Rite, Inc.). The light reflectance at 400 nm to 700 nm was also determined to obtain the average reflectance of visible light. The results are shown in Table 2.

(5) Determination of withstand voltage

A 10 kV breakdown tester (Yamayo Measuring Tools Co., ltd.) was used to measure in oil the withstand voltage of the radiation reflection plates for use in LEDs as obtained in Examples and Comparative Examples according to JIS C2110. The withstand voltage was measured at three points and the average of the measurements was calculated to obtain the withstand voltage. The results are shown in Table 2.

Table 1

| | Substrate | Pretreatment | Surface treatment | | | Sealing | Acid treatment |
| --- | --- | --- | --- | --- | --- | --- | --- |
| | | | Anodizing treatment (acids used, thickness of treated layer) | | | | |
| | | | Step 1 | Step 2 | Step 3 | (time) | (time) |
| EX 1 | 1 | Mirror finish | Sulfuric acid 30um | Boric acid 0.4um | - | Unperformed | Unperformed |
| EX 2 | 1 | Mirror finish | Sulfuric acid 30um | Boric acid 0.2um | - | Unperformed | Unperformed |
| EX 3 | 1 | Mirror finish | Sulfuric acid 30um | Boric acid 0.2um | - | Unperformed | Unperformed |
| EX 4 | 1 | Mirror finish | Sulfuric acid 50um | Boric acid 0.4um | - | Unperformed | Unperformed |
| EX 5 | 1 | Surface roughening | Sulfuric acid 30um | Boric acid 0.4um | - | Unperformed | Unperformed |
| EX 6 | 1 | Surface roughening | sulfuric acid 30um | Boric acid 0.1um | - | Unperformed | Unperformed |
| EX 7 | 1 | Surface roughening | Sulfuric acid 50um | Boric acid 0.4um | - | Unperformed | Unperformed |
| EX 8 | 1 | Surface roughening | Sulfuric acid 50um | Phosphoric acid 0.45um | - | Unperformed | Unperformed |
| EX 9 | 1 | Surface roughening | Phosphoric acid 50um | Sulfuric acid 0.4um | - | Unperformed | Unperformed |
| EX 10 | 1 | Surface roughening | Sulfuric acid 30um | Phosphoric acid 0.4um | Sulfuric acid 0.4um | Unperformed | Unperformed |
| EX 11 | 1 | Surface roughening | Sulfuric acid 0.3um | Phosphoric acid 20um | Sulfuric acid 0.4um | Unperformed | Unperformed |
| EX 12 | 1 | Surface roughening | Sulfuric acid 0.3um | Phosphoric acid 20um | - | Unperformed | Unperformed |

(continued)

| | Substrate | Pretreatment | Anodizing treatment (acids used, thickness of treated layer) | | | Sealing | Acid treatment |
|---|---|---|---|---|---|---|---|
| | | | Step 1 | Step 2 | Step 3 | (time) | (time) |
| EX 13 | 1 | Surface roughening | Phosphoric acid 20um | Sulfuric acid 0.4um | - | Unperformed | Unperformed |
| EX 14 | 1 | Surface roughening | Sulfuric acid 0.3um | Boric acid 0.4um | - | Unperformed | Unperformed |
| EX 15 | 1 | Surface roughening | Sulfuric acid 0.3um | Phosphoric acid 0.45um | - | Unperformed | Unperformed |
| EX 16 | 1 | Surface roughening | Sulfuric acid 30um | - | - | 20 min | 30 sec |
| EX 17 | 2 | Surface roughening | Sulfuric add 30um | Boric acid 0.4um | - | Unperformed | Unperformed |
| EX 18 | 2 | Mirror finish | Sulfuric acid 30um | Boric acid 0.4um | - | Unperformed | Unperformed |
| EX 19 | 3 | Surface roughening | Sulfuric acid 30um | Boric acid 0.4um | - | Unperformed | Unperformed |
| EX 20 | 3 | Mirror finish | Sulfuric acid 30um | Boric acid 0.4um | - | Unperformed | Unperformed |
| CE 1 | 1 | Surface roughening | Sulfuric acid 30um | - | - | Unperformed | Unperformed |
| CE 2 | 1 | Surface roughening | Sulfuric acid 50um | - | - | Unperformed | Unperformed |
| CE 3 | 1 | Surface roughening | Sulfuric acid 0.4um | - | - | Unperformed | Unperformed |
| CE 4 | 1 | Surface roughening | Phosphoric acid 20um | - | - | Unperformed | Unperformed |
| CE 5 | 1 | Surface roughening | Sulfuric acid 30um | - | - | 20 min | Unperformed |

Table 2

| | Film physical properties | | | Reflectance | | | Withstand voltage (V) |
|---|---|---|---|---|---|---|---|
| | Porosity (%) | | | @450nm | @350nm | 400-700nm | |
| | Layer 1 | Layer 2 | Layer 3 | | | | |
| EX 1 | 33% | 0% | - | 93% | 85% | 92% | 1K |
| EX 2 | 33% | 0% | - | 90% | 80% | 88% | 1K |
| EX 3 | 33% | 0% | - | 82% | 94% | 92% | 1K |
| EX 4 | 33% | 0% | - | 90% | 81% | 89% | 2K |
| EX 5 | 33% | 0% | - | 92% | 90% | 90% | 1K |
| EX 6 | 33% | 0% | - | 89% | 90% | 85% | 1K |

(continued)

| | Film physical properties | | | Reflectance | | | Withstand voltage (V) |
|---|---|---|---|---|---|---|---|
| | Porosity (%) | | | @450nm | @350nm | 400-700nm | |
| | Layer 1 | Layer 2 | Layer 3 | | | | |
| EX 7 | 33% | 0% | - | 89% | 86% | 88% | 2K |
| EX 8 | 33% | 42% | - | 91% | 76% | 85% | 2K |
| EX 9 | 45% | 33% | - | 88% | 70% | 88% | 2K |
| EX 10 | 33% | 42% | 33% | 95% | 85% | 93% | 1K |
| EX 11 | 33% | 45% | 33% | 98% | 86% | 94% | 1K |
| EX 12 | 33% | 44% | - | 96% | 81% | 90% | 1K |
| EX 13 | 45% | 33% | - | 93% | 80% | 89% | 1K |
| EX 14 | 33% | 0% | - | 98% | 88% | 95% | 0.2K |
| EX 15 | 33% | 42% | - | 96% | 84% | 91% | 0.2K |
| EX 16 | 0% | 33% | - | 90% | 80% | 87% | 1K |
| EX 17 | 33% | 0% | - | 91% | 87% | 88% | 1K |
| EX18 | 33% | 0% | - | 89% | 82% | 84% | 1K |
| EX 19 | 33% | 0% | - | 92% | 82% | 90% | 1K |
| EX 20 | 33% | 0% | - | 90% | 82% | 86% | 1K |
| CE 1 | 33% | - | - | 85% | 80% | 82% | 1K |
| CE 2 | 33% | - | - | 82% | 76% | 80% | 2K |
| CE 3 | 33% | - | - | 90% | 84% | 89% | 0K |
| CE 4 | 45% | - | - | 80% | 72% | 77% | 1K |
| CE 5 | 0% | - | - | 86% | 78% | 84% | 1K |

**Claims**

1. A radiation reflection plate for use in LEDs comprising an aluminum alloy layer having an anodized film with a depth of 1$\mu$m or more formed at a surface thereof,
   wherein the anodized film comprises pore portions, and the at least one pore portion comprises at least two layers which have different refractive indices in a depth direction.

2. The radiation reflection plate for use in LEDs according to claim 1, wherein the layers having the at least one pore portion comprising at least two layers are layers of different porosities, and wherein when layers adjacent in the depth direction under a surface side layer p are represented by p+1, p+2, ... p+n, a vertical depth L of the layer p+1 is represented by formulas (1), (2-1) and (2-2):

$$L = 1/2 \times m \times \lambda \times n_{avp}/n_{avp+1} \qquad \text{Formula (1)}$$

$$n_{avp} = n_{Al2O3} \times (1-D_p) + n_{air} \times D_p \qquad \text{Formula (2-1)}$$

$$n_{avp+1} = n_{Al2O3} \times (1-D_{p+1}) + n_{air} \times D_{p+1} \qquad \text{Formula (2-2)}$$

where $\lambda$ is a wavelength of light for reflection, m is an integer of at least 1, $n_{avp}/n_{avp+1}$ is an refractive index ratio between the surface side layer p of the anodized film and its underlying layer p+1 in the at least two different layers,

$n_{Al2O3}$ is a refractive index of anodized alumina,

$n_{air}$ is a refractive index of air which is 1,

$n_{avp}$ is a refractive index of the layer p, $n_{avp+1}$ is a refractive index of the layer p+1,

$D_p$ is a porosity of the layer p, and

$D_{p+1}$ is a porosity of the layer p+1.

3. The radiation reflection plate for use in LEDs according to claim 1 or 2, wherein the at least two layers are layers of the different porosities obtained by anodizing under different conditions.

4. The radiation reflection plate for use in LEDs according to any one of claims 1 to 3, wherein a ratio of a center-line length of the pore portions to a depth of the pore portions is from 1.0 to 1.2.

5. The radiation reflection plate for use in LEDs according to any one of claims 1 to 4, wherein the aluminum alloy layer is in a shape having a recess and the anodized film is formed at the surface of the aluminum alloy layer in the shape having the recess.

6. The radiation reflection plate for use in LEDs according to any one of claims 1 to 5, which has an interconnect layer made of a metal conductor on a surface of the anodized film and is used to mount a light-emitting device.

7. An LED package comprising: an LED chip and an interconnect layer made of a metal conductor on a surface of the radiation reflection plate for use in LEDs according to any one of claims 1 to 6.

8. A white LED package comprising: a blue LED light-emitting device formed on the radiation reflection plate for use in LEDs according to any one of claims 1 to 6 and a fluorescent emitter provided around and/or above the blue LED light-emitting device.

9. A method of manufacturing the radiation reflection plate for use in LEDs according to any one of claims 1 to 6 comprising the steps of: subjecting a surface of an aluminum alloy layer to a first anodizing treatment in an aqueous acid solution; and performing a second anodizing treatment in an aqueous acid solution different from that used in the first anodizing treatment to form in pore portions of an anodized film at least two layers of different refractive indices in a depth direction.

10. A method of manufacturing the radiation reflection plate for use in LEDs according to any one of claims 1, 2 and 4 to 6, comprising the steps of: subjecting a surface of an aluminum alloy layer to a first anodizing treatment in an aqueous acid solution; and performing sealing treatment to form in pore portions of an anodized film at least two layers of different refractive indices in a depth direction.

# FIG. 1

CURRENT
VALUE

CURRENT PEAK

⊕

0

TIME

⊖

TP

TP

# FIG. 2

# FIG. 3

# FIG. 4

# FIG. 5A

# FIG. 5B

**REFERENCES CITED IN THE DESCRIPTION**

**Patent documents cited in the description**

- JP 55154564 U
- JP 2007250315 A
- JP 2007266358 A
- JP 2008270158 A
- JP 54081133 A
- JP 57047894 A
- JP 57051289 A
- JP 57051290 A
- JP 57054300 A
- JP 57136596 A
- JP 58107498 A
- JP 60200256 A
- JP 62136596 A
- JP 63176494 A
- JP 4176897 A
- JP 4280997 A
- JP 6207299 A
- JP 5024377 A
- JP 5032083 A
- JP 5125597 A
- JP 5195291 A
- JP 54012853 A
- JP 48045303 A
- JP 48026638 A
- JP 47018739 A
- JP 58024517 B
- JP 56012518 B
- JP 4004194 A
- JP 5202496 A
- JP 5179482 A
- JP 2008 A
- JP 93652 A
- JP 2009065076 A
- SE 650666680
- JP 2010283057 A
- JP 2010285640 A